# NOUVEAU FASCICULE DE BREVET EUROPEEN

(11) **EP 0 363 235 B2**
(45) Date de publication et mention de la décision concernant l'opposition: **06.10.1999**
(45) Mention de la délivrance du brevet: 09.11.1994
(21) Numéro de dépôt: 89402448.8
(22) Date de dépôt: 07.09.1989
(51) Int. Cl.: G03F 7/16, H01L 21/00

(54) **Procédé et dispositif pour l'application uniformément régulière d'une couche de résine sur un substrat**
Verfahren und Vorrichtung zur gleichmässigen Beschichtung eines Substrats mit einer Photolackschicht
Process and apparatus for the uniform application of a resist layer to a substrate

(30) Priorité: 15.09.1988 FR 8812045
(43) Date de publication de la demande: 11.04.1990
(73) Titulaire: KARL SUSS TECHNIQUE, F-74490 Saint Jeoire (FR)
(72) Inventeur: Cavazza, Gilbert, F-74250 Viuz En Sallaz (FR)
(74) Mandataire: Bonnetat, Christian

(56) Documents cités:
- DE-A- 1 811 863
- JP-A- 143 871
- JP-A- 62 185 321
- US-A- 4 031 852
- PATENT ABSTRACTS OF JAPAN, vol. 11, no. 259 (C-441)[2706], 21 août 1987 & JP-A-62 61 670
- PATENT ABSTRACTS OF JAPAN, vol. 9, no. 230 (E-343)[1953], 17 septembre 1985 & JP-A-60 84 816
- PATENT ABSTRACTS OF JAPAN, vol. 9, no. 318 (E-366)[2041], 13 décembre 1985 & JP-A-60 152 029

## Description

La présente invention concerne un procédé, et un dispositif en vue de la mise en oeuvre du procédé, permettant la répartition et le dépôt d'un film en couche mince d'un produit liquide à la surface d'un substrat notamment par un effet de centrifugation.

L'invention trouvera son application plus particulière dans le cadre de la déposition d'une couche extrêmement mince d'une résine photo-sensible à la surface d'un substrat de matière quelconque notamment en métal semi-conducteur tel que le silicium.

On sait que notamment dans le cadre de la réalisation de circuits intégrés, supposant la réalisation d'étage ou couches successives chacune comportant un réseau conducteur, on procède pour la réalisation de chaque étage au dépôt d'une couche de résine photo-sensible sur un substrat laquelle est ensuite insolée avec interposition d'un masque approprié, suivi d'une fixation pour réaliser le réseau correspondant à l'étage considéré.

La réalisation de circuits intégrés ultra-miniaturisés exige des dépôts de résine photo-sensible (ci-après désignée "résine") de plus en plus mince, de façon à permettre l'obtention d'une définition extrêmement fine au niveau de chaque étage.

La technique couramment utilisée pour obtenir un film de résine en couche mince consiste à déposer la résine à l'état liquide, en solution dans un solvant, sur le substrat récepteur, généralement une plaquette circulaire ou quadrangulaire.

La plaquette est préalablement déposée et maintenue sur un plateau giratoire ; le plateau est immédiatement soumis à rotation ce qui provoque par l'effet de la force centrifuge l'étalement en couche extrêmement mince et uniforme du liquide constitué de la solution de résine et du solvant sur la surface du substrat.

L'extrême volatilité du solvant contraint à effectuer la mise en rotation avec de fortes accélérations de sorte que l'étalement correct soit obtenu avant que l'évaporation du solvant ne modifie de manière trop importante la viscosité du mélange solvant + résine.

Le dépôt initial de la résine en solution peut s'effectuer alors que la plaquette est à l'état immobile ; mais on peut également déposer la résine en solution dans une phase initiale au cours de laquelle le substrat est déjà en rotation à faible vitesse ce qui facilite le mouvement de dispersion initiale sur l'ensemble de la surface ; la rotation rapide avec forte accélération ultérieure vise à éliminer de la surface du substrat l'excès de résine qui est alors projetée à l'extérieur et qui est recueillie sur les parois d'un bol à l'intérieur duquel est monté le plateau giratoire.

La recherche de films d'épaisseur de plus en plus réduite sur des substrats de taille de plus en plus grande conduit à la mise en oeuvre de techniques de plus en plus fines jouant respectivement sur la nature de la résine en solution notamment sa concentration, les propriétés notamment la volatilité du solvant ainsi que sur les conditions opératoires notamment la vitesse de la rotation, l'intensité de l'accélération, etc. On mentionnera simplement pour mémoire les précautions indispensables liées à la parfaite pureté et à la stabilité de l'environnement notamment par l'élimination de toute poussière dont le dépôt engendrerait une source de distorsion inacceptable au niveau de l'échelle de miniaturisation exigée.

Il est cependant clair que plus on augmente la taille du substrat tout en diminuant l'épaisseur du film de résine déposé, en cherchant notamment à obtenir des épaisseurs de film inférieures au micron, on multiplie les difficultés et les conditions opératoires deviennent de plus en plus difficiles à conduire et à maîtriser pour obtenir non seulement un film de résine d'épaisseur réduite, mais ce qui est indispensable, un film de résine constant et homogène en épaisseur.

Il reste en effet nécessaire que le film soit d'une parfaite régularité dans son épaisseur sur toute la surface du substrat.

Indépendamment de la nature (viscosité, liée à la concentration) de la solution de résine, on peut chercher à réduire l'épaisseur en agissant sur l'accélération et sur la vitesse de rotation ; on utilise ainsi des accélérations pouvant porter la vitesse de rotation jusqu'à 10.000 tours par minute en une seconde.

Cependant, l'expérience montre que l'on rencontre alors des problèmes qui sont liés à des interférences entre l'air ou le volume gazeux statique situé au-dessus du substrat et le substrat tournant ainsi que le film liquide en cours de fixation qu'il porte.

Les accélérations ainsi mises en oeuvre ne permettent pas à un gradient de vitesse de déplacement de l'air (ou de la couche gazeuse) située au-dessus du substrat de s'établir et les interférences entre la surface liquide entraînée en rotation en cours de stabilisation et de durcissement d'une part et l'air statique ou semi-statique d'autre part provoque des interférences se traduisant par des distorsions de surface sous forme de rides ou vagues, décelables notamment par des moyens optiques.

Mais surtout la technique ainsi décrite, devient parfaitement inadaptée lorsque l'on veut réaliser l'étalement de résine sur des substrats de forme quadrangulaire par exemple en vue de leur exploitation dans le cadre de la réalisation d'écrans plats.

En effet, lorsque le substrat quadrangulaire, notamment carré, est mis en rotation, chaque angle constitue un bord d'attaque de l'air et engendre par conséquent une turbulence qui interfère fortement avec l'écoulement et la répartition du film liquide sur la surface du substrat.

De sorte que la réalisation de plaquettes ou substrats carrés porteurs d'un film de résine photo-sensible, s'accompagne conséquemment dans chaque angle d'une zone révélant les traces des turbulences rencontrées par le liquide lors de sa répartition et aboutissant notamment à des inégalités d'épaisseur du film de résine se traduisant notamment par des segments de spires marquant les angles du substrat.

De sorte qu'il apparaît actuellement impossible, dans le cadre des techniques existantes, de réaliser des plaquettes ou substrats carrés portant un film de résine en couche mince et d'épaisseur uniforme, en utilisant les techniques giratoires et de centrifugation précédemment décrites.

L'invention répond à ce problème et permet d'éviter les interférences entre le substrat tournant porteur de la résine en cours d'étalement et le volume gazeux dans lequel il est inséré. Elle répond également aux difficultés d'augmentation de la surface enduite du film de résine par un meilleur contrôle de l'évaporation du solvant.

Et l'invention permet donc d'obtenir des substrats quadrangulaires aussi bien que circulaires et comportant un film de résine en couche mince, d'une épaisseur régulière parfaite et homogène descendant en dessous du micron.

Le procédé et le dispositif de l'invention permettent par ailleurs de conserver les possibilités de modulation et d'adaptation de l'épaisseur en utilisant un choix sélectif de la résine dans son solvant.

A cette fin, selon l'invention, le procédé pour revêtir un substrat, notamment en une matière semi-conductrice, telle que le silicium, ou en une matière minérale, telle que le verre, d'une couche de résine, par exemple photosensible, en vue de la fabrication de composants, notamment électroniques ou optiques, procédé dans lequel une dose de résine en solution est déposée sur le substrat en position sur un plateau circulaire rotatif, la résine étant étalée en couche mince par la rotation rapide et accélérée du plateau en même temps que l'évaporation du solvant laisse subsister sur le substrat la couche de résine d'épaisseur souhaitée, procédé selon lequel on superpose sur le plateau circulaire un couvercle concentrique en forme de cuvette renversée en définissant un volume gazeux enfermant le substrat et on provoque la mise en rotation de ce couvercle avec le plateau, de sorte que ledit volume gazeux soit entraîne en rotation synchrone avec le plateau et le couvercle, est caractérisé en ce que l'on applique ledit couvercle sur ledit plateau circulaire de façon qu'il repose par ses bords, sans étanchéité, sur ledit plateau circulaire et que ledit volume gazeux enfermant le substrat soit clos, pour soustraire la surface du substrat en rotation et porteur de la résine en solution dans le solvant en cours d'évaporation, à toute interférence avec l'atmosphère gazeuse ambiante et, cependant, permettre à l'excès de résine en solution dégagée depuis le substrat de fluer sous l'action de la force centrifuge entre ledit plateau et ledit couvercle.

On remarquera que le document japonais No.60-143871 décrit un procédé semblable à celui correspondant à la partie précaractérisante de la définition ci-dessus. Cependant, dans ce document, on prévoit des ouvertures ou fentes périphériques, de sorte que le volume gazeux enfermant le substrat n'est pas clos, mais ouvert. L'atmosphère autour du substrat est donc turbulente.

On remarquera également que le document "Patent Abstracts of Japan, vol.ll, N°259 (C-441) (2706), 21.08.87 of JP-A-62 61 670", divulgue un procédé pour revêtir un substrat d'une couche d'un agent de recouvrement, procédé dans lequel une dose de cet agent est déposée sur le substrat en position sur un plateau circulaire rotatif, cet agent étant ensuite étalé en couche mince par mise en rotation rapide du plateau. Ce procédé connu montre que l'on superpose au plateau circulaire un couvercle concentrique plat définissant avec le plateau circulaire un volume gazeux ouvert périphériquement, de sorte que, en fonctionnement, de l'air est aspiré centralement et éjecté à la périphérie ouverte du volume gazeux entre le plateau et le couvercle plat.

Par ailleurs, le document "Patent Abstracts of Japan, Vol.9, N°230 (E-343) (1953), 17.09.85 of JP-A-60 84 816" décrit un dispositif pour uniformiser un revêtement de résine mince sur un substrat au moyen d'une aile réduisant l'influence de la résistance de l'air.

La présente invention concerne de plus un dispositif pour la mise ne oeuvre du procédé selon l'invention, destiné au revêtement d'un substrat, notamment en une matière semi-conductrice, telle que le silicium, ou en une matière minérale, telle que le verre, par une couche de résine, notamment photosensible, en vue de la fabrication de composants, notamment électroniques ou optiques, ledit dispositif comportant une source de résine en solution apte à déposer une dose de résine sur la surface du substrat, et un plateau récepteur du substrat et muni de moyens d'immobilisation dudit substrat sur le plateau, de sorte que la rotation du plateau provoque l'étalement en couche mince de la résine sur la surface du substrat, ledit dispositif comportant un couvercle de cloisonnement en forme de cuvette renversée permettant d'enfermer ledit substrat dans l'espace gazeux situé au-dessus du plateau et étant apte à être mis en rotation synchrone avec le plateau, de façon à entraîner la couche d'atmosphère gazeuse située au-dessus du substrat dans un mouvement de rotation synchrone avec ce dernier, est caractérisé en ce que ledit couvercle de cloisonnement repose par ses bords sur le plateau, au-delà des bords du substrat et en ce que l'appui du bord du couvercle sur le plateau est réalisé sans étanchéité, permettant ainsi le passage et l'échappement par suite de la force centrifuge de l'excès de résine en solution dégagée depuis le substrat.

Le couvercle peut être est monté amovible pour permettre la mise en place du substrat et éventuellement le dépôt initial de résine et ce couvercle est monté sur un axe de rotation apte à venir en position colinéaire par rapport à l'axe de rotation du plateau inférieur, en permettant ainsi la mise en rotation harmonisée synchrone et concentrique entre le plateau et le couvercle avec entraînement du couvercle par le plateau.

Selon une autre caractéristique, le couvercle est monté à rotation sur un bras transversal apte à surplomber diamétralement le plateau rotatif, et ce bras supportant le couvercle est déplaçable entre une position effacée permettant l'accès au plateau en vue de la dépose ou de l'enlèvement du substrat et éventuellement du dépôt initial de la résine et une position active dans laquelle le couvercle est amené au contact et repose sur le plateau.

Selon une autre caractéristique, le bras est porteur du couvercle par l'intermédiaire d'un axe de rotation formé d'un roulement dont le centre est laissé libre pour permettre le passage du conduit d'amenée de la résine en solution et aboutissant à une ou plusieurs buses de déversement surplombant le plateau.

Selon encore une autre caractéristique, le bras porteur du couvercle est monté articulé latéralement, et il est déplaçable angulairement dans un plan vertical et diamétral au plateau rotatif, de façon à pouvoir être déplacé entre une position effacée et une position active dans laquelle il surplombe diamétralement le plateau en maintenant le couvercle en position de repos sur ledit plateau.

Le bras peut comporter des moyens de verrouillage permettant son immobilisation dans la position active comme dans la position inactive.

Selon encore une autre caractéristique l'appui du couvercle maintenu sur le plateau récepteur par le bras, est obtenu par l'intermédiaire d'un ressort taré à une valeur permettant un appui du couverde tel qu'il laisse fluer la résine en solution entre le plateau inférieur et le couverde supérieur lors de la phase de centrifugation.

D'autres caractéristiques et avantages de l'invention ressortiront de la description qui suit et qui est donnée en rapport avec une forme de réalisation plus particulière présentée à titre d'exemple et en relation avec les dessins annexés.

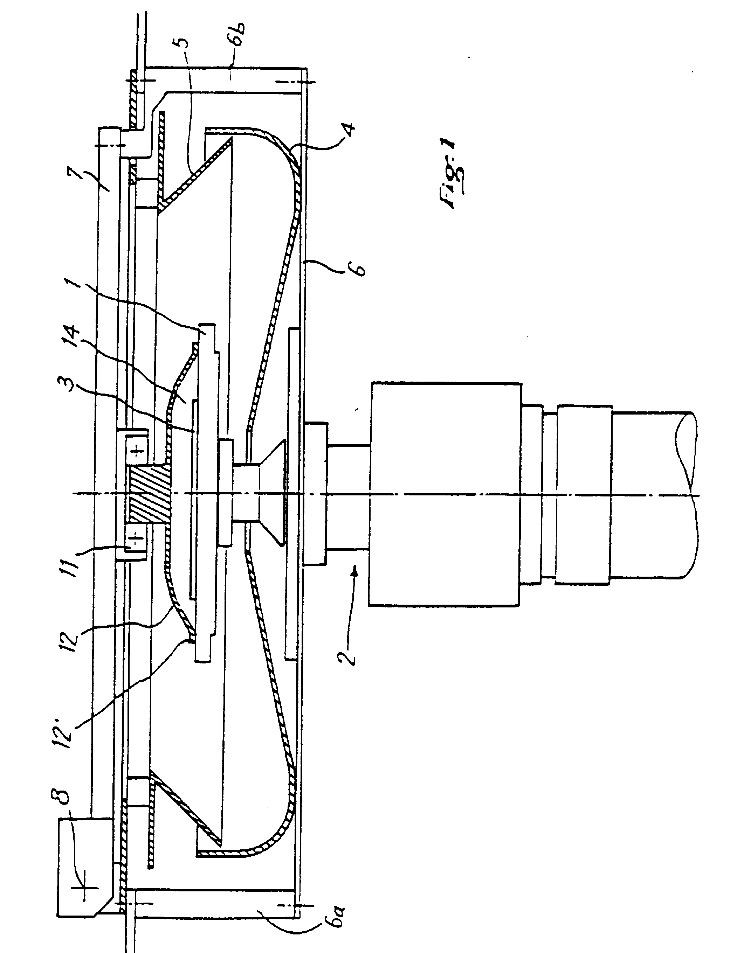

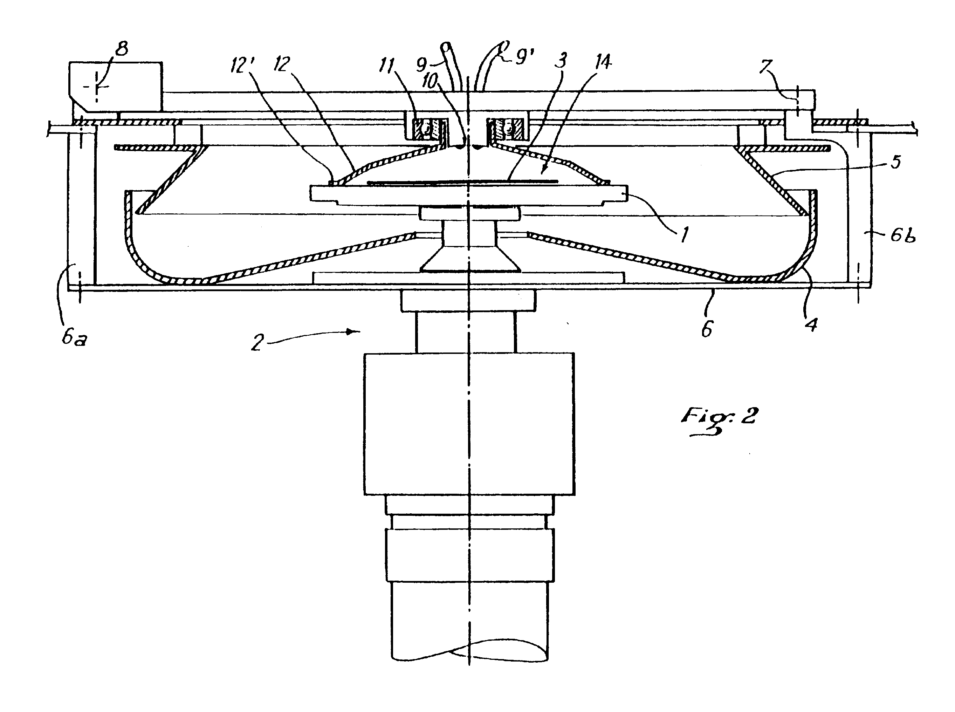

Les figures 1 et 2 représentent une vue schématique et en coupe horizontale d'un plateau de centrifugation réalisé conformément à l'invention.

Selon les figures 1 et 2, on a représenté le plateau tournant 1 monté sur un arbre vertical 2 entraîné depuis un dispositif moteur en position inférieure (non représenté).

Sur le plateau 1 est posé le substrat 3 formé ici d'un substrat de forme carrée ou circulaire.

Le substrat 3 est maintenu en position sur le plateau 1, notamment lors de la phase de mise en rotation avec accélération rapide, par un dispositifde succion relié à une autre source de vide (non représentée) et traversant la partie centrale du plateau récepteur 1.

Autour de ce dispositif tournant est maintenu un ensemble fixe constitué du bol inférieur 4 et du déflecteur supérieur 5.

Le bol inférieur 4 est monté sur le socle 6 et il comporte en sa partie centrale une lumière traversée par l'axe 2.

De son côté le déflecteur supérieur 5 est monté fixe sur le socle 6 et 7 qui surplombe le plateau 1 et le bol périphérique 4.

Le bras 7 est articulé en 8 et il est ainsi déplaçable selon un plan vertical diamètral par rapport au plateau tournant 1, selon l'axe 8.

Le bras 7 est ainsi déplaçable entre une position effacée dans laquelle il est sensiblement vertical au-dessus de l'axe 8 et une position active dans laquelle il surplombe le plateau et tel que représenté sur la figure.

Selon la figure 2, ce bras est traversé en sa partie centrale par les conduits respectivement 9 et 9' qui permettent l'arrivée de la résine en solution dans un solvant volatil approprié et débouchant vers la buse inférieure 10 surplombant elle-même la plaquette réceptrice 3.

Et selon l'invention, le bras 7 supporte un roulement couronne 11 dont la partie centrale est dégagée pour permettre le passage des conduits 9 et 9' et sur ce roulement est monté rotatif le couverde 12.

Selon les figures 1 et 2, ce couverde en forme de cuvette inversée vient reposer par ses bords 12' sur la paroi supérieure du plateau 1 tandis que sa partie centrale est montée tournante sur le roulement 11.

L'axe de rotation du couverde Il est strictement colinéaire avec l'axe de rotation du plateau 1.

De sorte que lors de la mise en rotation du plateau, le mouvement se communique naturellement au couverde 12.

Le bras 7 peut être verrouillé sur l'ensemble constitué par le socle 6 et les montants latéraux 6a, 6b.

La pression du couverde 12 sur le plateau inférieur 1 est tarée de façon à éviter tout contact d'étanchéité entre les bords du couvercle 12' et le plateau 1.

On comprend le fonctionnement de l'ensemble ainsi décrit.

Selon la figure 2, initialement la buse 10 dépose une quantité appropriée de résine dans son solvant volatil sur le substrat 3 lequel peut être entraîné alors en rotation lente pour permettre une première répartition de la résine dans son solvant sur la surface du substrat.

Après quoi on augmente la vitesse de rotation du plateau 1 ce qui provoque le déport centrifuge de la résine dans son solvant vers l'extérieur.

Dans le même temps, le solvant extrêmement volatil se trouve partiellement confiné entre le plateau 1 et le couverde 12.

Mais la rotation simultanée et homogène de l'ensemble foré par le plateau 1 et son couverde 12 entraîne en même temps la mise en rotation de l'atmosphère intérieure confinée entre le couvercle 12 et le plateau 1, de sorte que l'atmosphère gazeuse située au-dessus du substrat est entraînée en rotation en même temps ou sensiblement en même temps que cette dernière en évitant ainsi les interférences, les tourbillons et les risques de distorsion dans la répartition du film liquide constitué par la résine en solution sur la surface du substrat.

Et ceci est également obtenu dans le cas où le substrat est de formée carrée.

Dans ce cas en effet les parties angulaires formées par les coins du substrat ne sont plus amenées à pénétrer violemment et à vitesse accélérée l'atmosphère gazeuse laquelle, enfermée et confinée entre le plateau et le couverde, se trouvent entraîné en rotation sensiblement en même temps et soumise à la même accélération que le substrat et le film liquide qui constituent l'interface entre le substrat et l'atmosphère gazeuse.

Cependant on a évité de provoquer un contact étanche entre les bords du couvercle et le plateau de sorte que l'excès de résine en suspension, à l'état liquide, projeté violemment vers l'extérieur, peut se glisser et fluer entre le plateau et le couvercle pour s'échapper de la chambre constituée par l'espace intérieur défini entre le plateau et le couverde ; on évite ainsi un excès de solution et notamment de solvant qui risquerait d'empoisonner l'atmosphère intérieure de la chambre par une sursaturation en solvant risquant de provoquer en fin d'opération une déformation de surface du film de résine par le solvant.

On pourra notamment prévoir que l'espace en couronne qui entoure les tubulures centrales 9, 9' et le roulement Il peut être refermé ou dégagé suivant les circonstances et notamment suivant la viscosité (donc la concentration) de la solution et suivant en conséquence la tension de vapeur du solvant se dégageant lors de la réalisation du film.

On pourra également prévoir des chicanes radiales disposées sur la paroi intérieure du couvercle 12 de façon à diviser l'espace intérieur de la chambre 14 en une pluralité de secteurs cloisonnés les uns par rapport aux autres, chaque secteur correspondant à une atmosphère partielle au-dessus du substrat et chaque secteur entraînant son atmosphère propre en mouvement au-dessus du substrat et en évitant ainsi de façon encore plus complète toute distorsion et tout gradient de vitesse entre le film en cours de répartition et de séchage sur le substrat et son atmosphère correspondante le surplombant.

Les essais et expérimentations auxquels il a été procédé parla demanderesse ont permis ainsi de réaliser des films d'une parfaite régularité et d'une épaisseur allant jusqu'à un chiffre inférieur à 0,5 micron, correspondant à une définition particulièrement précise et fine dans la réalisation des circuits intégrés autorisant ainsi une miniaturisation particulièrement poussée.

## Revendications

1. Procédé pour revêtir un substrat, notamment en une matière semi-conductrice, telle que le silicium, ou en une matière minérale, telle que le verre, d'une couche de résine par exemple photosensible, en vue de la fabrication de composants, notamment électroniques ou optiques, procédé dans lequel une dose de résine en solution est déposée sur le substrat en position sur un plateau circulaire rotatif, la résine étant étalée en couche mince par la rotation rapide et accélérée du plateau en même temps que l'évaporation du solvant laisse subsister sur le substrat la couche de résine d'épaisseur souhaitée, procédé selon lequel on superpose sur le plateau circulaire (1) un couvercle concentrique (12) en forme de cuvette renversée en définissant un volume gazeux enfermant le substrat (3) et on provoque la mise en rotation de ce couvercle avec le plateau, de sorte que ledit volume gazeux soit entraîné en rorotation synchrone avec le plateau et le couvercle,
caractérisé en ce que l'on applique ledit couvercle (12) sur ledit plateau circulaire (1) de façon qu'il repose par ses bords, sans étanchéité, sur ledit plateau circulaire (1) et que ledit volume gazeux enfermant le substrat (3) soit clos, pour soustraire la surface du substrat en rotation et porteur de la résine en solution dans le solvant en cours d'évaporation, à toute interférence avec l'atmosphère gazeuse ambiante et cependant permettre à l'excès de résine en solution dégagée depuis le substrat de fluer sous l'action de la force centrifuge entre ledit plateau (1) et ledit couvercle (12).

2. Dispositif pour la mise en oeuvre du procédé selon la revendication 1, destiné au revêtement d'un substrat, notamment en une matière semi-conductrice, telle que le silicium, ou en une matière minérale, telle que le verre, par une couche de résine, notamment photosensible, en vue de la fabrication de composants, notamment électroniques ou optiques, ledit dispositif comportant une source de résine (9,9') en solution apte à déposer une dose de résine sur la surface du substrat, et un plateau (1) récepteur du substrat (3) et muni de moyens d'immobilisation dudit substrat sur le plateau, de sorte que la rotation du plateau (1) provoque l'étalement en couche mince de la résine sur la surface du substrat, ledit dispositif comportant un couvercle de cloisonnement en forme de cuvette renversée permettant d'enfermer ledit substrat dans l'espace gazeux situé au-dessus du plateau et étant apte à être mis en rotation synchrone avec le plateau, de façon à entraîner la couche d'atmosphère gazeuse située au-dessus du substrat dans un mouvement de rotation synchrone avec ce dernier,
caractérisé en ce que ledit couvercle de cloisonnement (12) repose par ses bords sur le plateau (1), au-delà des bords du substrat (3) et en ce que l'appui du bord du couvercle (12) sur le plateau (1) est réalisé sans étanchéité, permettant ainsi le passage et l'échappement par suite de la force centrifuge de l'excès de résine en solution dégagée depuis le substrat.

3. Dispositif selon la revendication 2,
caractérisé en ce que le couvercle (12) est monté amovible pour permettre la mise en place du substrat et éventuellement le dépôt initial de résine (3) et ce couvercle est monté sur un axe de rotation (11) apte à venir en position colinéaire par rapport à l'axe de rotation du plateau inférieur (1), en permettant ainsi la mise en rotation harmonisée synchrone et concentrique entre le plateau et le couvercle avec entraînement du couvercle par le plateau.

4. Dispositif selon l'une des revendications 2 ou 3,
caractérisé par le fait que le couvercle (12) est monté à rotation sur un bras transversal (7) apte à surplomber diamétralement le plateau rotatif (1), et ce bras supportant le couvercle est déplaçable entre une position effacée permettant l'accès au plateau en vue de la dépose ou de l'enlèvement du substrat et éventuellement du dépôt initial de résine, et une position active dans laquelle le couvercle est amené au contact et repose sur le plateau.

5. Dispositif selon la revendication 4,
caractérisé en ce que le bras (7) est porteur du couvercle (12) par l'intermédiaire d'un axe de rotation formé d'un roulement (11) dont le centre est laissé libre pour permettre le passage du conduit (9, 9') d'amenée de la résine en solution et aboutissant à une ou plusieurs buses de déversement surplombant le plateau.

6. Dispositif selon l'une des revendications 4 ou 5,
caractérisé en ce que le bras (7) porteur du couvercle (12) est monté articulé latéralement, et il est déplacable angulairement dans un plan vertical et diamétral au plateau rotatif (1) de façon à pouvoir être déplacé entre une position effacée et une position active dans laquelle il surplombe diamétralement le plateau en maintenant le couvercle en position de repos sur ledit plateau.

7. Dispositif selon l'une des revendications 4 à 6,
caractérisé en ce que le bras (7) comporte des moyens de verrouillage permettant son immobilisation dans la position active comme dans la position inactive.

8. Dispositif selon l'une des revendications 2 à 7,
caractérisé en ce que l'appui du couvercle (12) maintenu sur le plateau (1) récepteur par le bras (7), est obtenu par l'intermédiaire d'un ressort taré à une valeur permettant un appui du couvercle tel qu'il laisse fluer la résine en solution entre le plateau inférieur et le couvercle supérieur lors de la phase de centrifugation.

## Patentansprüche

1. Verfahren zur Beschichtung eines Substrats, insbesondere aus einem Halbleitermaterial, wie Silizium, oder aus einem mineralischen Material, wie Glas, mit einer beispielsweise lichtempfindlichen Harzschicht zur Herstellung insbesondere von elektronischen oder optischen Bauteilen, bei dem eine Dosis eines Harzes in Lösung auf das auf einem runden Drehteller befindliche Substrat aufgebracht wird, wobei das Harz durch die schnelle beschleunigte Drehung des Tellers in einer dünnen Schicht bei gleichzeitiger Verdampfung des Lösungsmittels aufgetragen wird, nach der auf dem Substrat die Harzschicht in der gewünschten Dicke verbleibt, wobei auf den Drehteller (1) ein konzentrischer Deckel (12) gelegt wird, der die Form einer umgekehrten Schale hat, so daß ein das Substrat (3) einschließendes Gasvolumen gebildet wird und dieser Deckel mit dem Teller in Drehung versetzt wird, so daß das Gasvolumen in eine mit dem Teller und dem Deckel synchrone Drehung gebracht wird, dadurch gekennzeichnet, daß der Deckel (12) derart auf dem Drehteller (1) aufgelegt wird, daß er mit seinen Rändern nichtabdichtend auf dem Drehteller (1) ruht und daß das Substrat (3) einschließende Gasvolumen abgeschlossen ist, um die Oberfläche des sich drehenden Substrats und Trägers des im Lösungsmittel gelösten Harzes während des Verdampfens gegenüber einer Beeinflussung durch die gasförmige Umgebungsatmosphäre abzuschirmen und dabei den Abfluss von überschüssigem, gelöstem Harz, das vom Substrat freigegeben wird, aufgrund der Wirkung der Zentrifugalkraft zwischen dem Teller (1) und dem Deckel (12) zu ermöglichen.

2. Vorrichtung für die Anwendung des Verfahrens nach Anspruch 1 für die Beschichtung eines Substrats, insbesondere aus einem Halbleitermaterial, wie Silizium, oder aus einem mineralischen Material, wie Glas, mit einer insbesondere lichtempfindlichen Harzschicht zur Herstellung insbesondere von elektronischen oder optischen Bauteilen, wobei die Vorrichtung eine Quelle eines Harzes in Lösung (9, 9'), mit der eine Harzdosis auf die Oberfläche des Substrats aufgebracht werden kann, und einen Aufnahmeteller (1) des Substrats (3) hat, der mit Mitteln zur Blockierung des Substrats auf dem Teller versehen ist, so daß durch die Drehung des Tellers (1) der Dünnschichtauftrag des Harzes auf der Oberfläche des Substrats erfolgt, wobei die Vorrichtung einen Zwischendeckel in der Form einer umgekehrten Schale hat und das Substrat in dem Gasraum über dem Teller einschließen und in eine mit dem Teller synchrone Drehung versetzt werden kann, so daß die Schicht der gasförmigen Atmosphäre über dem Substrat in eine zu diesem Teller synchrone Drehbewegung versetzt wird, dadurch gekennzeichnet, daß der Trenndeckel (12) mit seinen Rändern jenseits der Ränder des Substrats (3) auf dem Teller (1) ruht und daß die Auflage des Randes des Deckels (12) auf dem Teller (1) ohne Abdichtung realisiert ist, so daß überschüssiges gelöstes Harz, das vom Substrat freigegeben wird, auf Grund der Zentrifugalkraft hindurchtreten und entweichen kann.

3. Vorrichtung nach Anspruch 2, dadurch gekennzeichnet, daß der Deckel (12) abnehmbar angebracht ist, um das Auflegen des Substrats und gegebenenfalls das anfängliche Auftragen des Harzes (3) zu gestatten, und daß der Deckel an einer Drehachse (11) angeordnet ist, die für eine abgestimmte, synchrone und konzentrische Rotation zwischen Teller und Deckel koaxial zur Rotationsachse des unteren Tellers (1) ausrichtbar ist, wobei der Deckel durch den Teller angetrieben wird.

4. Vorrichtung nach einem der Ansprüche 2 oder 3, dadurch gekennzeichnet, daß der Deckel (12) drehbar an einem Querarm (7) befestigt ist, der den Drehteller (1) diametral überspannen kann, und daß der den Deckel tragende Arm zwischen einer rückgestellten Position, die den Zugang zum Teller zum Auflegen oder Abnehmen des Substrats und gegebenenfalls zum anfänglichen Auftragen des Harzes ermöglicht, und einer aktiven Position, in der der Deckel in Kontakt mit dem Teller gebracht ist und auf ihm ruht, verstellbar ist.

5. Vorrichtung nach Anspruch 4, dadurch gekennzeichnet, daß der Arm (7) den Deckel (12) über eine als Wälzlager (11) ausgebildete Drehachse trägt, dessen Zentrum freigelassen ist, um die Durchführung der Zuführleitung (9, 9') für die Harzlösung zu gestatten, die in eine oder mehrere den Teller überhängende Austrittsdüsen mündet.

6. Vorrichtung nach einem der Ansprüche 4 oder 5, dadurch gekennzeichnet, daß der den Deckel (12) tragende Arm (7) seitlich angelenkt ist und in einer zum Drehteller (1) senkrechten und diametralen Ebene winkelverstellbar ist, so daß er zwischen einer rückgestellten und einer aktiven Position, in der er diametral den Teller überhängt und den Deckel in Ruhestellung über dem Teller hält, verstellbar ist.

7. Vorrichtung nach einem der Ansprüche 4 bis 6, dadurch gekennzeichnet, daß der Arm (7) eine Verriegelungseinrichtung aufweist, durch die er sowohl in der aktiven als auch in der inaktiven Position feststellbar ist.

8. Vorrichtung nach einem der Ansprüche 2 bis 7, dadurch gekennzeichnet, daß die Auflage des durch den Arm (7) über dem Aufnahmeteller (1) gehaltenen Deckels (12) über eine Feder erzielt wird, die auf einen Wert eingestellt ist, der eine Auflage des Deckels derart zuläßt, daß während der Zentrifugationsphase die Harzlösung zwischen den unteren Teller und dem oberen Deckel fließen kann.

## Claims

1. Method for coating a substrate, especially consisting of a semi-conductive material, such as silicon, or of a mineral material, such as glass, with a resin coating, for example photosensitive, in view of producing in particular optical or electronic components, method in which a resin dose in solution is deposited on the substrate in position on a circular rotary plate, the resin being spread as a thin layer by the fast and accelerated rotation of the plate at the same time as evaporation of the solvent allows the resin coating of the desired thickness to be present on the substrate, method according to which a concentric cover (12) in form of an inverted cup is superimposed on the circular plate (1) defining thereby a gaseous volume enclosing the substrate (3) and this cover is made to rotate with the plate so that said gaseous volume is driven in rotation synchronously with the plate and the cover,
characterized in that said cover (12) is applied on said circular plate (1), such that it rests with its edges, without tightness, on said circular plate (1), and that said gaseous volume enclosing the substrate (3) is closed, in order to prevent any interference of the surface of the substrate rotating and carrying the resin in solution in the solvent which is evaporating, with the ambient gaseous atmosphere and, however, to allow the excess of resin in solution released from the substrate to creep under the action of the centrifugal force between said plate (1) and said cover (12).

2. Device for implementing the method according to claim 1 and intended to coat a substrate, especially consisting of a semi-conductive material, such as silicon, or of a mineral material, such as glass, with a resin coating, in particular photosensitive, in view of producing in particular optical or electronic components, said device comprising a resin source (9, 9') in solution suitable for depositing a resin dose on the surface of the substrate and a plate (1) receiving the substrate (3) and provided with means for rendering said substrate stationary on the plate so that the rotation of the plate (1) generates the spreading of the resin as a thin layer over the surface of the substrate, said device comprising a confining cover in form of an inverted cup allowing said substrate to be enclosed inside the gaseous space located above the plate and being suitable for being rotated synchronously with the plate so as to drive the gaseous atmosphere layer located above the substrate in a rotary motion synchronously with the latter,
characterized in that said confining cover (12) rests with its edges on the plate (1) beyond the edges of the substrate (3) and in that the edge of the cover (12) rests on the plate (1) without tightness, thus allowing the passage and the escape of the excess of resin in solution released from the substrate under the action of the centrifugal force.

3. Device according to claim 2,
characterized in that the cover (12) is releasibly mounted so as to allow for placing of the substrate and possibly the initial depositing of the resin (3), this cover being mounted on a rotation axis (11) suitable for coming into a collinear position with respect to the rotation axis of the lower plate (1), thus allowing for the matched synchronous and concentric rotation between the plate and the cover, said cover being driven by the plate.

4. Device according to either claim 2 or 3,
characterized in that the cover (12) is rotatably mounted on a transversal arm (7) suitable for diametrically overhanging the rotary plate (1), this arm supporting the cover being able to be moved between a retracted position, allowing for access to the plate in view of depositing or removing the substrate and possibly the initial resin deposit, and an active position in which the cover is brought into contact and rests on the plate.

5. Device according to claim 4,
characterized in that the arm (7) supports the cover (12) by means of a rotation axis formed by a rolling bearing (11) whose center is left free so as to allow for the passage of the admission pipe (9, 9') of the resin in solution and ending at one or more discharging nozzles overhanging the plate.

6. Device according to one of claims 4 or 5,
characterized in that the arm (7) supporting the cover (12) is laterally articulated and is able to be moved angularly within a vertical plane diametrical to the rotary plate (1) so as to be able to be moved between a retracted position and an active position in which it diametrically overhangs the plate by keeping the cover in the rest position on said plate.

7. Device according to one of claims 4 to 6,
characterized in that the arm (7) comprises locking means enabling to fix said arm in the active position as well as in the inactive position.

8. Device according to one of claims 2 to 7,
characterized in that the support of the cover (12) kept on the receiving plate (1) by the arm (7) is obtained by means of a spring calibrated to a value allowing for a support of the cover such that it allows the resin in solution to creep between the lower plate and the upper cover during the centrifuging phase.
